# EUROPÄISCHE PATENTSCHRIFT

(11) **EP 0 647 021 B1**
(45) Veröffentlichungstag und Bekanntmachung des Hinweises auf die Patenterteilung: **23.06.1999**
(21) Anmeldenummer: 94114846.2
(22) Anmeldetag: 21.09.1994
(51) Int. Cl.: H03H 7/42

(54) **Schaltungsanordnung zur Anpassung eines erdunsymmetrischen Leitungssystems an ein erdsymmetrisches Leitungssystem**
Balanced-unbalanced circuit arrangement
Circuit de conversion symétrique-dissymétrique

(30) Priorität: 30.09.1993 DE 4333253
(43) Veröffentlichungstag der Anmeldung: 05.04.1995
(73) Patentinhaber: Daimler-Benz Aerospace Aktiengesellschaft, 81663 München (DE)
(72) Erfinder: Dey, Holger, Dr.-Ing., D-61239 Ober-Mörlen (DE)
(74) Vertreter: Fröhling, Werner Otto, Dr.

(56) Entgegenhaltungen:
- DE-A- 3 140 724
- US-A- 4 201 962
- US-A- 4 631 504
- QST AMATEUR RADIO, Bd.53, Nr.4, April 1969, NEWINGTON US Seiten 42 - 43 R.H. TURRIN 'Application of broad-band balun transformers'

## Beschreibung

Die Erfindung betrifft eine Schaltungsanordnung zur Anpassung eines erdunsymmetrischen Leitungssystems an ein erdsymmetrisches Leitungssystem nach dem Oberbegriff des Patentanspruchs 1.

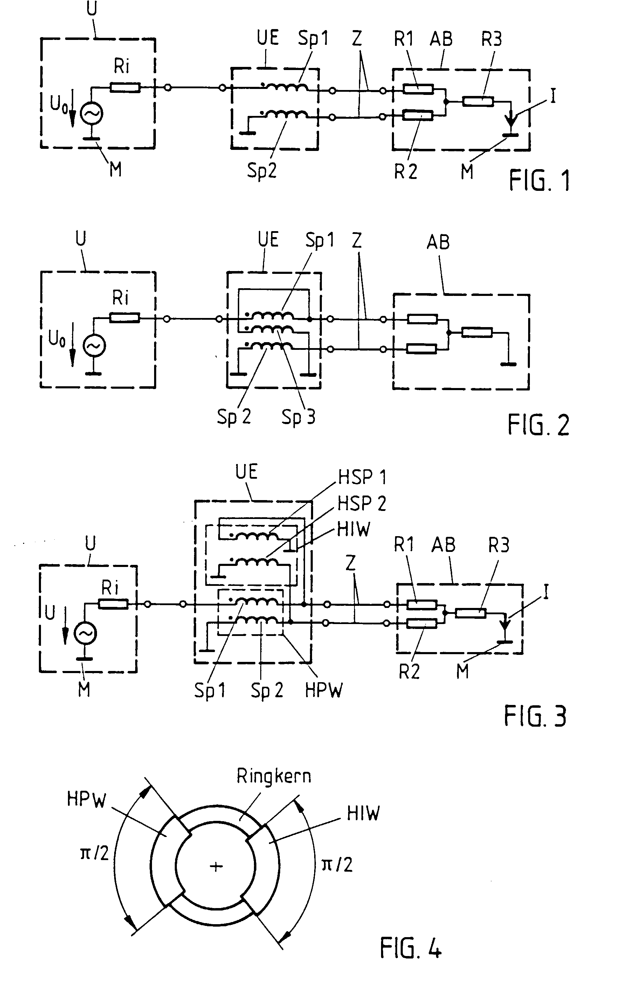

In vielen Bereichen der Elektronik und/oder der Nachrichtentechnik ist es erforderlich, von einem erdunsymmetrischen Leitungssystem, z.B. einer Koaxialleitung, auf ein erdsymmetrisches Leitungssystem, z.B. eine Zweidrahtleitung, zu wechseln. Für einen solchen Übergang sind Schaltungsanordnungen mit Hilfe von Übertragern bekannt, z.B. aus Meinke/Gundlach: Taschenbuch der Hochfrequenztechnik, 2. Auflage, 1962, S. 382-391 sowie aus Zinke/Brunswig: Lehrbuch der Hochfrequenztechnik, 4. Auflage 1990, S. 120-133. Solche bekannten Schaltungsanordnungen sind in den Figuren 1 und 2 schematisch dargestellt.

FIG. 1 zeigt eine reale Wechselspannungsquelle U, bestehend aus einer Hintereinanderschaltung aus einer idealen Spannungsquelle Uₒ (Innenwiderstand = 0) und einem Innenwiderstand Ri, z.B. 100 Ohm. Bei der Spannungsquelle U liegt ein Ausgangsanschluß an Masse M (Erde), d.h. auf dem Potential OV, so daß eine erdunsymmetrische Spannungsquelle U entsteht. An diese ist ein Übertrager UE angeschlossen. Dieser enthält einen magnetisierbaren (Spulen-)Kern mit einer darauf aufgewickelten Zweidrahtleitung, die darstellbar ist als zwei Spulen Sp 1, Sp 2, zwischen denen eine elektrische und eine magnetische Kopplung besteht. Die Spulen Sp 1, Sp 2 werden im folgenden auch Hauptwicklung genannt. Mit dem dargestellten Punkt wird der jeweilige Spulenanfang gekennzeichnet. Ein solcher Übertrager UE wird auch Zweidraht-Differentialübertrager genannt. An dessen Ausgang ist ein erdsymmetrisches Leitungssystem Z, z.B. eine Zweidrahtleitung, angeschlossen. Dieses ist durch einen Abschlußwiderstand AB, der z.B. die Widerstände R 1, R 2, R 3 enthält, symmetrisch gegen Masse abgeschlossen, das heißt, R1 = R2. Dabei ist ein Anschluß des Widerstandes R 3 mit Masse M verbunden.

Infolge des Magnetisierungsstroms des Übertragers ist bei dieser Anordnung allerdings I ≠ O, d. h. die Symmetrie ist gestört.

Die in Figur 2 dargestellte Schaltungsanordnung unterscheidet sich von derjenigen der Figur 1 lediglich dadurch, daß der Übertrager UE als sogenannter Dreidraht-Übertrager ausgebildet ist. Dieser besitzt eine zusätzliche Spule Sp 3, welche den Magnetisierungsstrom führt. Eine solche Anordnung hat bei hohen Frequenz insbesondere den Nachteil, daß eine störende elektrische Unsymmetrie durch ein unterschiedliches Stehwellen-Verhältnis (SWR) der verschiedenen möglichen Mehrleiter-Moden bei einem elektrischen Fehlabschluß des Übertragers UE entsteht.

Aus der Druckschrift "QST Amateur Radio", Band 53 (April 1969) sind verschiedene Ausführungen von Balun (balanced-to-unbalanced)-Transformatoren bekannt, die ebenfalls eine Hilfswicklung aufweisen, die zur Magnetisierung des Spulenkerns dient und die Anwendbarkeit der Transformatoren im Bereich der untere Frequenzen erweitern soll. Allerdings können auch diese Hilfswicklungen bei hohen Frequenzen die oben genannten Nachteile aufweisen.

Der Erfindung liegt die Aufgabe zugrunde, eine gattungsgemäße Schaltungsanordnung anzugeben, die in einem weiten Frequenzbereich einen verlustarmen Übergang zwischen einem erdunsymmetrischen und einem erdsymmetrischen Leitungssystem ermöglicht und die weitgehend unempfindlich ist gegen einen möglichen Fehlabschluß des Übertragers.

Diese Aufgabe wird gelöst durch die in den kennzeichnenden Teilen des Patentanspruchs 1 angegebenen Merkmale. Vorteilhafte Ausgestaltungen und/oder Weiterbildungen sind den Unteransprüchen entnehmbar.

Ein erster Vorteil der Erfindung besteht darin, daß eine Impedanztransformation bei der Anpassung allenfalls eine vernachlässigbare elektrische Unsymmetrie (bezüglich Masse) bei dem erdsymmetrischen Leitungssystem erzeugt.

Ein zweiter Vorteil besteht darin, daß bei dem erdsymmetrischen Leitungssystem ein hoher Wellenwiderstand wählbar ist, so daß insbesondere bei einer Antennenspeisung geringe elektrische Verluste entstehen.

Ein dritter Vorteil besteht darin, daß die Schaltungsanordnung eine niedrige Gleichtakt-Innenimpedanz besitzt, so daß eine sehr gute Symmetrie bei dem erdsymmetrischen Leitungssystem vorhanden ist auch wenn dieses unsymmetrisch belastet ist bezüglich Masse.

Weitere Vorteile ergeben sich aus der nachfolgenden Beschreibung.

Die Erfindung wird im folgenden anhand eines Ausführungsbeispieles unter Bezugnahme auf die schematisch dargestellte FIG. 3 näher erläutert. Die dort schematisch dargestellte Schaltungsanordnung unterscheidet sich von denjenigen der FIG. 1 und 2 lediglich durch eine andere Ausbildung des Übertragers UE. Dieser enthält zusätzlich zu der bereits erwähnten Hauptwicklung HPW mit den Spulen Sp 1, Sp 2 eine Hilfswicklung HIW mit den Hilfsspulen HSP 1 und HSP 2, was nachfolgend noch näher erläutert wird.

In einem Ausführungsbeispiel entsprechend FIG. 3 ist die Spannungsquelle U als Antennenanpaßgerät bis zu einem Stehwellenverhältnis von 1000 : 1 für einen Frequenzbereich von 2 MHz bis 20 MHz ausgebildet. An den erdunsymmetrischen Ausgang der Spannungsquelle U ist der Übertrager UE unmittelbar angeschlossen. Dieser enthält einen magnetisierbaren Kern, der vorzugsweise als Ringkern ausgebildet ist und aus einem für den angegebenen Frequenzbereich geeignetem Ferrit-Material hergestellt ist. Der Ringkern hat beispielsweise einen kreisringförmigen Querschnitt mit einem Außendurchmesser von ungefähr 36 mm, einem Innendurchmesser von ungefähr 23 mm sowie eine Höhe von ungefähr 14 mm. Auf diesem Ringkern ist die Hauptwicklung HPW aufgewickelt. Diese besteht beispielsweise aus 15 Windungen einer verdrillten Zweidrahtleitung, das heißt, die Spulen Sp 1, Sp 2 bestehen jeweils aus 15 Windungen, haben also immer dieselbe Windungszahl. Die Hauptwicklung HPW ist als räumlich kompakte Wicklung ausgeführt, das heißt, die Hauptwicklung beansprucht maximal π/2 des Außenumfangs des Ringkerns. Die Zweidrahtleitung besteht aus elektrisch isolierten Drähten, die für den angegebenen Frequenzbereich geeignet sind. Die Hauptwicklung HPW ist, wie in FIG. 1, so geschaltet, daß eine Anpassung des erdungssymmetrischen Leitungssystems an das erdsymmetrische Leitungssystem Z erfolgt. Dabei ist der Spulenanfang, in FIG. 3 durch einen Punkt gekennzeichnet, der ersten Spule Sp 1 an den Ausgang der Spannungsquelle U (Antennenanpaßgerät) angeschlossen. Bei der zweiten Spule Sp 2 liegt der Spulenanfang auf Masse (Erde). An die Spulenenden der Spulen Sp 1, Sp 2 ist das erdsymmetrische Leitungssystem Z angeschlossen, das durch den Abschlußwiderstand AB abgeschlossen ist.

Auf dem Ringkern ist weiterhin eine Hilfswicklung HIW angebracht. Diese ist entsprechend der Hauptwicklung aufgebaut. Die Hilfswicklung HIW besteht daher ebenfalls aus 15 Windungen einer verdrillten Zweidrahtleitung aus demselben Drahtmaterial, so daß die Hilfsspulen HSP 1, HSP 2 entstehen. Es ist besonders wichtig, daß die Hilfswicklung HIW räumlich getrennt von der Hauptwicklung HPW auf dem Ringkern aufgewickelt ist. Dazu wird die Hilfswicklung HIW in einem der Hauptwicklung diametral gegenüberliegenden Bereich des Ringkerns angeordnet (FIG. 4). Die Hilfswicklung umfaßt dabei ungefähr ebenfalls einen Außenumfangsbereich von π/2. Bei der Hilfswicklung HIW ist der Spulenanfang der ersten Hilfsspule HSP 1 mit dem Spulenende der ersten Spule Sp 1 verbunden. Das Spulenende der ersten Hilfsspule HSP 1 liegt an Masse. Der Spulenanfang der zweiten Hilfsspule HSP 2 liegt ebenfalls an Masse, während das zugehörige Spulenende mit dem Spulenende der zweiten Spule SP 2 verbunden ist. Mit der Hilfswicklung HIW wird erreicht, daß in einem weiten Frequenzbereich, z.B. in dem Frequenzbereich von 2 MHz bis 20 MHz, in dem Übertrager UE immer ein Magnetisierungsstrom vorhanden ist derart, daß der von dem Widerstand R 3 zu Masse M fließende Strom I immer vernachlässigbar ist auch bei sich ändernden Widerstandswerten der Widerstände R 1 = R 2, R 3. Dieses ist beispielsweise dann der Fall, wenn der Abschlußwiderstand AB als Antenne, z.B. als Sendeantenne für den Kurzwellenbereich (2 MHz bis 20 MHz), ausgebildet ist. Eine solche Antenne ist dann durch ein Ersatzschaltbild darstellbar, welches dem Abschlußwiderstand AB (Widerstände R 1 bis R 3) entspricht.

Bei einem derartigen Übertrager UE sind Spulen verwendbar, deren elektrische Spulenlängen vorteilhafterweise jeweils größer als λ/10 sind, wobei λ die Wellenlänge des zu übertragenden elektrischen Signals bezeichnet.

Aufgrund der in dem Übertrager UE vorhandenen niedrigen Gleichtakt-Innenimpedanz trifft bei dem erdsymmetrischen Leitungssystem Z eine vernachlässigbare Unsymmetrie von allenfalls 0,2 dB auf. Diese Werte bleiben vorteilhafterweise auch bei einer stark unsymmetrischen Belastung erhalten, daß heißt, auch dann, wenn der Abschlußwiderstand AB sich derart ändert, das ein Stehwellenverhältnis von 1000 : 1 bzgl. des Leitungswellenwiderstands von z. B. Z = 100 Ω entsteht.

Die Erfindung ist nicht auf das beschriebene Beispiel beschränkt, sondern sinngemäß auf weitere anwendbar. Beispielsweise ist zwischen dem erdunsymmetrischen und dem erdsymmetrischen Leitungssystem eine von 1:1 abweichende Impedanzanpassung möglich.

Eine solche Schaltungsanordnung ist außerdem zum Ansteuern einer Gegentaktstufe geeignet, die vorzugsweise als Leistungsstufe ausgebildet ist.

## Patentansprüche

1. Schaltungsanordnung zur Anpassung eines erdunsymmetrischen Leitungssystems an ein erdsymmetrisches Leitungssystem, bei der
-- die Anpassung mit Hilfe eines zwischen die Leitungssysteme geschalteten Übertragers mit magnetisch gekoppelten Spulen erfolgt,
-- auf einem magnetisierbaren Kern des Übertragers (UE) zur elektrischen Anpassung des erdunsymmetrischen Leitungssystems an das erdsymmetrische Leitungssystem eine Hauptwicklung (HPW) vorhanden ist,
-- die Hauptwicklung (HPW) aus einer Zweidrahtleitung besteht, so daß eine erste und eine zweite Spule (Sp 1, Sp 2) entstehen,
-- auf dem magnetisierbaren Kern zusätzlich eine Hilfswicklung (HIW) vorhanden ist, die aus einer Zweidrahtleitung besteht, so daß eine erste und eine zweite Hilfsspule (HSP 1, HSP 2) entstehen und
-- die Haupt- sowie die Hilfswicklung räumlich getrennt auf dem magnetisierbaren Kern angeordnet sind, dadurch gekennzeichnet, daß
-- die Hauptwicklung und die Hilfswicklung (HPW, HIW) jeweils aus verdrillten Zweidrahtleitungen bestehen und
-- jeweils die gleiche Wicklungszahl aufweisen und
-- bei jeder Spule der Hilfswicklung (HIW) jeweils ein Spulenende mit der Systemerde (Masse) und das jeweils andere Ende mit jeweils einem Leiter des erdsymmetrischen Leitungssystems (Z) verbunden ist, und
wobei die erste Spule der Hauptwicklung sowohl an das erdunsymmetrische als auch an das erdsymmetrische Leitungssystem angeschlossen ist.

2. Schaltungsanordnung nach Anspruch 1, dadurch gekennzeichnet, daß der magnetisierbare Kern als magnetisierbarer Ringkern ausgebildet ist.

3. Schaltungsanordnung nach einem der vorhergehenden Ansprüche, dadurch gekennzeichnet, daß die Haupt- und die Hilfswicklung (HPW, HIW) diametral gegenüber auf dem Ringkern angeordnet sind.

4. Schaltungsanordnung nach einem der vorhergehenden Ansprüche, dadurch gekennzeichnet, daß das erdsymmetrische Leitungssystem (Z) als Antenne zum Aussenden elektromagnetischer Wellen ausgebildet ist.

5. Schaltungsanordnung nach einem der vorhergehenden Ansprüche, dadurch gekennzeichnet, daß mindestens eine der Spulen (SP 1, Sp 2) eine elektrische Leitungslänge größer λ/10 besitzt, wobei λ die zu dem zu übertragenden elektrischen Signal gehörende Wellenlänge ist.

6. Schaltungsanordnung nach einem der vorhergehenden Ansprüche, dadurch gekennzeichnet, daß die Antenne als Sendeantenne für den Kurzwellenbereich ausgebildet ist.

7. Schaltungsanordnung nach einem der vorhergehenden Ansprüche, dadurch gekennzeichnet, daß das erdsymmetrische Leitungssystem als Gegentaktstufe ausgebildet ist.

## Claims

1. Circuit arrangement for matching an unbalanced line system to a balanced line system, in which
- the matching is carried out with the aid of a transformer, which is connected between the line systems, with magnetically coupled coils,
- a main winding (HPW) is present on a magnetisable core of the transformer (UE) for electrical matching of the unbalanced line system to the balanced line system,
- the main winding (HPW) consists of a two-wire line, so that a first and a second coil (Sp 1, Sp 2) arise,
- an auxiliary winding (HIW) is additionally present on the magnetisable core and consists of a two-wire line, so that a first and a second auxiliary coil (HSP 1, HSP 2) arise and
- the main winding and auxiliary winding are arranged on the magnetisable core to be spatially separate, characterised in that
- the main winding and the auxiliary winding (HPW, HIW) each consist of twisted two-wire lines and
- each have the same winding number and
- one coil end of each coil of the auxiliary winding (HIW) is connected with the system earth (ground) and the respective other end with a respective line of the balanced line system (2) and wherein the first coil of the main winding is connected to both the unbalanced line system and the balanced line system.

2. Circuit arrangement according to claim 1, characterised in that the magnetisable core is constructed as a magnetisable ring core.

3. Circuit arrangement according to one of the preceding claims, characterised in that the main and the auxiliary winding (HPW, HIW) are arranged diametrically opposite on the ring core.

4. Circuit arrangement according to one of the preceding claims, characterised in that the balanced line system (Z) is constructed as an antenna for the emitting of electromagnetic waves.

5. Circuit arrangement according to one of the preceding claims, characterised in that at least one of the coils (SP 1, SP2) has an electrical line length greater than λ/10, wherein λ is the wavelength belonging to the electrical signal to be transformed.

6. Circuit arrangement according to one of the preceding claims, characterised in that the antenna is constructed as a transmitting antenna for the shortwave range.

7. Circuit arrangement according to one of the preceding claims, characterised in that the balanced line system is constructed as a push-pull stage.

## Revendications

1. Circuit d'adaptation d'un système de lignes dissymétrique par rapport à la terre à un système de lignes symétrique par rapport à la terre, dans lequel
- l'adaptation s'effectue à l'aide d'un transformateur monté entre les systèmes de lignes avec des bobines couplées magnétiquement,
- sur un noyau magnétisable du transformateur (UE) est prévu, en vue de l'adaptation électrique du système de lignes dissymétrique par rapport à la terre au système de lignes symétrique par rapport à la terre, un enroulement principal (HPW),
- l'enroulement principal (HPW) se compose d'une ligne bifilaire, de manière à obtenir une première et une seconde bobines (Sp1, Sp2),
- sur le noyau magnétisable est en outre prévu un enroulement auxiliaire (HIW), qui se compose d'une ligne bifilaire, de manière à obtenir une première et une seconde bobine auxiliaire (HSP1, HSP2) et
- l'enroulement principal, ainsi que l'enroulement auxiliaire, sont disposés séparés spatialement sur le noyau magnétisable, caractérisé en ce que
- l'enroulement principal et l'enroulement auxiliaire (HPW, HIW) se composent respectivement de lignes bifilaires torsadées et
- présentent chacun le même nombre de spires et
- dans chaque bobine de l'enroulement auxiliaire (HIW), une extrémité de bobine est reliée à la terre du système (masse) et l'autre extrémité est reliée à un conducteur du système de lignes symétrique par rapport à la terre, et
- la première bobine de l'enroulement principal est reliée non seulement au système de lignes dissymétrique par rapport à la terre mais également au système de lignes symétrique par rapport à la terre.

2. Circuit selon la revendication 1, caractérisé en ce que le noyau magnétisable est réalisé sous la forme d'un noyau annulaire magnétisable.

3. Circuit selon l'une quelconque des revendications précédentes, caractérisé en ce que l'enroulement principal et l'enroulement auxiliaire (HPW, HIW) sont disposés diamétralement opposés sur le noyau annulaire.

4. Circuit selon l'une quelconque des revendications précédentes, caractérisé en ce que le système de lignes symétrique par rapport à la terre (Z) est constitué par une antenne d'émission d'ondes électromagnétiques.

5. Circuit selon l'une quelconque des revendications précédentes, caractérisé en ce qu'au moins une des bobines (Sp1, Sp2) possède une longueur de ligne électrique supérieure à λ/10, λ étant la longueur d'onde appartenant au signal électrique à transmettre.

6. Circuit selon l'une quelconque des revendications précédentes, caractérisé en ce que l'antenne est réalisée en tant qu'antenne d'émission pour la gamme ondes courtes.

7. Circuit selon l'une quelconque des revendications précédentes, caractérisé en ce que le système de lignes symétrique par rapport à la terre est réalisé sous la forme d'un étage symétrique.
